(19) Europäisches Patentamt
European Patent Office
Office européen des brevets

(11) **EP 2 066 037 B1**

(12) **FASCICULE DE BREVET EUROPEEN**

(45) Date de publication et mention
de la délivrance du brevet:
**24.02.2010 Bulletin 2010/08**

(51) Int Cl.:
***H03M 1/10*** *(2006.01)*    *H03M 1/12* *(2006.01)*

(21) Numéro de dépôt: **08169755.9**

(22) Date de dépôt: **24.11.2008**

(54) **Procédé de vérification du fonctionnement d'un module d'entrées analogiques et module d'entrées analogiques mettant en oeuvre ce procédé**

Funktionsüberprüfungsverfahren eines Moduls für Analogeingänge und Modul für Analogeingänge, bei dem dieses Verfahren umgesetzt wird

Method of checking the operation of an analogue entry module and analogue entry module implementing this method

(84) Etats contractants désignés:
**AT BE BG CH CY CZ DE DK EE ES FI FR GB GR HR HU IE IS IT LI LT LU LV MC MT NL NO PL PT RO SE SI SK TR**

(30) Priorité: **26.11.2007 FR 0759314**

(43) Date de publication de la demande:
**03.06.2009 Bulletin 2009/23**

(73) Titulaire: **Schneider Electric Industries SAS
92500 Rueil-Malmaison (FR)**

(72) Inventeurs:
• **Grosjean, Dominique
06650 Le Rouret (FR)**
• **Delplanque, Nicolas
69100 Villeurbanne (FR)**

(74) Mandataire: **Dufresne, Thierry et al
Schneider Electric Industries SAS
Service Propriété Industrielle
35 rue Joseph Monier - CS 30323
92506 Rueil-Malmaison Cedex (FR)**

(56) Documents cités:
**US-A- 4 580 126     US-A1- 2005 264 306
US-B1- 6 492 923**

EP 2 066 037 B1

Printed by Jouve, 75001 PARIS (FR)

**Description**

La présente invention concerne un procédé de test ou de vérification du fonctionnement d'un module d'entrées analogiques d'un automate programmable. Elle concerne également un module d'entrées analogiques d'un automate programmable apte à mettre en oeuvre un tel procédé. L'invention trouve une application particulièrement avantageuse dans le domaine des automates programmables dits de sécurité.

Un automate programmable ou PLC («Programmable Logical Controller») est un équipement d'automatisme capable de piloter, commander et/ou surveiller un ou plusieurs process à automatiser. De construction généralement modulaire, un automate programmable PLC est composé de différents modules placés dans un ou plusieurs racks et qui communiquent entre eux par un bus de transmission, qui peut être notamment le bus dit «fond de panier» (ou «backplane») d'un rack de fixation des modules. Le nombre de modules dépend bien entendu de la taille et du type de process à automatiser. Typiquement, un automate programmable comprend :

- un module d'alimentation fournissant les différentes tensions aux autres modules à travers le bus fond de panier.

- un module unité centrale qui comporte un logiciel embarqué («firmware») intégrant un système d'exploitation (OS) temps réel, et un programme d'application, ou programme utilisateur, contenant les instructions à exécuter par le logiciel embarqué pour effectuer les opérations d'automatisme souhaitées. Le module unité centrale comporte aussi généralement une connexion en face avant vers des outils de programmation de type ordinateur personnel PC.

- un ou plusieurs modules de communication vers des réseaux de communication (Ethernet, ...) ou des interfaces homme-machine (écran, clavier,...).

- des modules d'entrées/sorties E/S de divers types en fonction du ou des process à commander, tels que E/S numériques, analogiques, de comptage, etc. Ces modules E/S sont reliés à des capteurs et à des actionneurs participant à la gestion automatisée du process.

L'invention s'adresse plus particulièrement aux modules d'entrées analogiques, c'est-à-dire à des modules qui reçoivent des données analogiques provenant de capteurs externes, capteurs de température, de pression, etc., et qui doivent convertir ces données analogiques en données numériques avant de les transmettre généralement au module unité centrale.

Dans le contexte d'un automatisme de sécurité où l'automate programmable doit présenter un niveau de sécurité renforcé, le bon fonctionnement des modules d'entrées analogiques liés à l'automate doit être surveillé de manière à pouvoir se fier aux données analogiques reçues, lesquelles sont connues à travers les données numériques fournis par ces modules. En effet, pour chacune de ses voies d'entrées analogiques, le module d'entrées analogiques comporte un convertisseur analogique/numérique ADC («Analog Digital Converter») qui transforme la valeur analogique lue sur l'entrée analogique en un signal numérique à destination du module unité centrale de l'automate, par exemple via le bus fond de panier. Un module d'entrées analogiques de sécurité peut évidemment comporter plusieurs voies d'entrées analogiques, par exemple 4, 8 ou 16 voies.

Les organismes de contrôle et de certification produits pour la sécurité demandent notamment de vérifier régulièrement un certain nombre de points de mesure de fonctionnement, par exemple 5 points de mesure répartis sur l'ensemble de l'échelle d'une entrée analogique, de manière à vérifier notamment le bon fonctionnement de la conversion analogique/numérique faite par le convertisseur ADC. On parle alors de «module de sécurité» pour désigner un module d'entrées analogiques dont le fonctionnement de la conversion analogique/numérique est ainsi contrôlé.

La vérification d'un convertisseur analogique/numérique est bien connue de US-A-4,580,126.

Cependant, pour faire cette vérification, il faut avoir un dispositif capable de créer ces différents points de mesure de fonctionnement. Il faut donc pouvoir disposer d'une tension de référence pour générer ces points de mesure, distincte de l'alimentation du module, ce qui entraîne des difficultés en termes de coût, d'encombrement, de complexité, etc.

Aussi, un but de l'invention est de pouvoir effectuer une vérification du fonctionnement des mesures d'un module de sécurité pour automate programmable, en proposant un procédé qui permettrait de répondre aux exigences de certification, concernant en particulier la vérification du bon fonctionnement et de la bonne alimentation du convertisseur analogique/numérique ADC, sans nécessiter l'utilisation d'une source de tension de référence spécifique ou sans passer par une électronique de surveillance de tension plus compliquée à mettre en oeuvre, avec amplificateurs opérationnels, diodes Zener, etc. pour réaliser une tension de référence.

Pour cela, l'invention décrit un procédé de vérification du fonctionnement d'un module d'entrées analogiques d'un automate programmable, le module comprenant un convertisseur analogique/numérique ADC qui est apte à convertir un signal analogique reçu sur une entrée en un signal numérique délivré sur une sortie, et qui est alimenté par une première tension de valeur nominale $V_1$. Le procédé consiste à équiper le module d'un convertisseur numérique/analogique DAC comportant une première sortie connectée à l'entrée du convertisseur ADC et une entrée, et apte à convertir un signal numérique reçu sur l'entrée en un signal analogique délivré sur la première sortie. Le convertisseur DAC est alimenté par une deuxième tension de valeur nominale $V_2$ distincte de la première tension nominale $V_1$. Le procédé consiste ensuite à appliquer un signal numérique de test St au convertisseur DAC, lire un signal numérique de réponse Sr correspondant délivré sur la sortie du convertisseur ADC et comparer le signal de test St audit signal de réponse Sr, à l'aide d'un rapport de correspondance prédéterminé entre les tensions nominales $V_1$ et $V_2$, pour vérifier le fonctionnement du module.

Selon une caractéristique, le procédé prévoit d'appliquer périodiquement plusieurs signaux numériques de test St couvrant une plage de mesure du convertisseur ADC, et compare chaque signal de test St à un signal de réponse correspondant Sr, à l'aide du rapport de correspondance prédéterminé. Ceci permet de vérifier le bon fonctionnement du module sur l'ensemble de l'échelle de mesure de la voie analogique.

Si une des comparaisons montre un rapport entre St et Sr différent du rapport de correspondance, alors cela signifie que la voie considérée du module est défectueuse. Le procédé peut bien entendu être appliqué à toutes les voies d'un module d'entrées analogiques.

Selon une autre caractéristique, l'entrée du convertisseur ADC est reliée à une borne d'entrée d'une voie de mesure du module au travers d'une impédance d'adaptation Ra. Le convertisseur DAC comporte une seconde sortie qui est connectée à l'entrée du convertisseur ADC au moyen d'une impédance de charge Rs. Le procédé comprend également les étapes consistant à :

- enregistrer un premier signal numérique de mesure S par le convertisseur ADC après conversion d'un signal analogique de mesure E,
- générer un signal analogique de test E' délivré par le convertisseur DAC en réponse à un signal numérique de test St' appliqué à l'entrée du convertisseur DAC,
- enregistrer un second signal numérique S' délivré par le convertisseur ADC après conversion d'un signal analogique résultant de la combinaison du signal analogique E de mesure et du signal analogique de test E',
- comparer les signaux numériques S et S', à l'aide des valeurs nominales des impédances d'adaptation Ra et de charge $R_s$ et de la valeur du signal numérique de test St', pour vérifier le fonctionnement du module.

L'invention décrit également un module d'entrées analogiques susceptible de mettre en oeuvre un tel procédé de vérification.

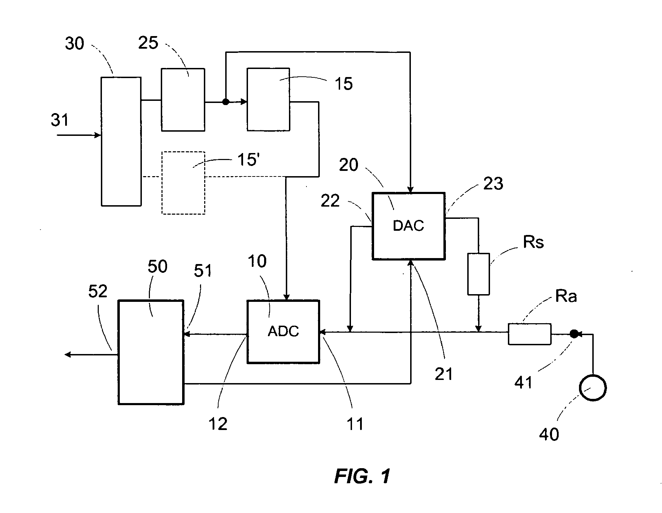

D'autres caractéristiques et avantages vont apparaître dans la description détaillée qui suit en se référant à un mode de réalisation donné à titre d'exemple et représenté par les dessins annexés sur lesquels la figure 1 représente un schéma fonctionnel simplifié d'une voie d'un module d'entrées analogiques conforme à l'invention.

Un module d'entrées analogiques d'un automate programmable comporte une ou plusieurs voies d'entrée. En référence à la figure 1, chaque voie d'entrée du module comporte une borne d'entrée 41 destinée à recevoir sous forme analogique un signal de mesure fourni par un capteur 40 de mesure tel qu'un capteur de température, un capteur de pression, etc.

De façon usuelle, la borne d'entrée 41 de la voie est ensuite reliée à une entrée 11 d'un convertisseur analogique/numérique ADC 10 via une impédance d'adaptation Ra. Le convertisseur ADC 10 est destiné à convertir le signal de mesure analogique reçu sur son entrée 11 en un signal numérique délivré sur sa sortie 12. Le module d'entrées analogiques comporte donc généralement un convertisseur analogique/numérique ADC 10 par voie. La sortie 12 du convertisseur ADC 10 est ensuite reliée à une entrée 51 d'une unité de commande 50 du module. L'unité de commande 50 transmet ensuite ce signal numérique sur son port de sortie 52, à destination du module unité centrale de l'automate programmable, via par exemple le bus fond de panier.

Le convertisseur ADC 10 est alimenté par un premier régulateur 15 de tension sous une tension d'alimentation dont la valeur nominale est égale à $V_1$. A titre d'exemple, ladite tension nominale d'alimentation $V_1$ sera prise égale à 4V. Ce premier régulateur 15 de tension est de préférence un régulateur de tension précis qui doit fournir une référence de tension précise au convertisseur ADC 10 afin d'avoir une bonne précision sur la mesure de l'entrée analogique.

Comme le montre la figure 1, le module d'entrées analogiques de sécurité comprend également un convertisseur numérique/analogique DAC 20 comportant une entrée 21 et une première sortie 22. Le convertisseur DAC 20 est destiné à convertir un signal numérique reçu sur l'entrée 21 en un signal analogique délivré sur la sortie 22. Cette première sortie 22 est connectée directement à l'entrée 11 du convertisseur ADC 10 sous basse impédance, c'est-à-dire avec une impédance de sortie très faible devant l'impédance d'adaptation Ra, de sorte que lorsqu'elle du convertisseur DAC 20 est activée, la sortie 22 se comporte comme un générateur de tension pour le convertisseur ADC 10. Ainsi, lorsque le convertisseur DAC 20 envoie une tension donnée sur sa sortie 22, cette tension vient forcer l'entrée 11 du convertisseur ADC 10, même si un signal est appliqué sur la borne d'entrée analogique 41 du module car celle-ci a une impédance plus élevée due à l'impédance d'adaptation Ra.

Le convertisseur DAC 20 est alimenté par un deuxième régulateur 25 de tension sous une tension d'alimentation dont la valeur nominale est égale à $V_2$ qui est choisie distincte de la tension nominale d'alimentation $V_1$ du convertisseur ADC 10 (par exemple $V_2$ = 5V). On verra plus loin la raison de ce choix de tensions nominales d'alimentation $V_1$ et $V_2$ distinctes pour les deux convertisseurs.

Ainsi, quand le convertisseur DAC 20 reçoit une tension égale à sa tension nominale d'alimentation $V_2$ de 5V, il délivre une tension de 5V sur sa sortie 22 lorsqu'il reçoit un signal numérique à pleine échelle sur son entrée 21. Quand le convertisseur ADC 10 reçoit une tension égale à sa tension nominale d'alimentation V1 de 4V, il fournit un signal numérique pleine échelle sur sa sortie 12 dès qu'il reçoit 4V sur son entrée 11.

Un premier test d'intégrité permet notamment de vérifier le bon fonctionnement des convertisseurs ADC 10 et DAC 20 et la bonne alimentation de ces convertisseurs. Pour réaliser ce premier test d'intégrité, l'unité de commande 50 envoie un signal numérique de test St sur l'entrée 21 du convertisseur DAC 20. Le signal St est transformé par le convertisseur DAC 20 en un signal analogique sur sa première sortie 22 et est donc envoyé sur l'entrée 11 du convertisseur ADC 10. En réponse, celui-ci fournit sur sa sortie 12 un signal numérique de réponse Sr transmis à l'unité de commande 50.

Par ailleurs, l'unité de commande 50 est munie de moyens de traitement et de mémorisation lui permettant de comparer chaque signal numérique de test St envoyé au convertisseur DAC 20 avec un signal numérique correspondant de réponse Sr fourni par le convertisseur ADC 10. Cette comparaison est faite à l'aide d'un rapport de correspondance prédéterminé entre les tensions nominales d'alimentation $V_1$ et $V_2$ fournies par les régulateurs 15, 25.

Dans l'exemple choisi, les tensions nominales $V_1$ et $V_2$ sont respectivement égales à 4V et 5V. Dans ce cas, le rapport de correspondance prédéterminé est égal à 4/5, ce qui signifie que si aucun dysfonctionnement du module ne se produit, aussi bien au niveau des convertisseurs 10 et 20, qu'au niveau des valeurs des tensions d'alimentation fournies par les régulateurs 15, 25, il doit exister un rapport de 4/5 entre un signal numérique de test St envoyé et le signal de réponse Sr correspondant.

En effet, si l'unité de commande 50 envoie un signal St = 80 (c'est-à-dire par exemple 80% de la pleine échelle), le convertisseur DAC va alors fournir en sortie une tension égale à 80% de sa pleine échelle, à savoir 5V * 80% = 4V. Ce signal analogique de 4V se retrouve en entrée du convertisseur ADC 10 et correspond à 100% de l'échelle du convertisseur ADC 10. Celui-ci va donc délivrer un signal numérique de réponse Sr = 100. Ainsi, le rapport entre St et Sr est bien égal à 80/100, soit 4/5.

Lorsque la comparaison donne un rapport entre St et Sr égal au rapport de correspondance prédéterminé, le test d'intégrité est correct. Dans le cas contraire, l'unité de commande 50 est notamment capable d'envoyer un message de défaut ou d'alerte à l'unité centrale du PLC pour signaler un dysfonctionnement de la voie concernée du module.

Le premier test d'intégrité est préférentiellement réalisé par l'unité de commande 50 en appliquant sur l'entrée 21 du convertisseur DAC 20 différents signaux numériques de test St correspondant, par exemple à N points de mesure (i=1,2,...,N) couvrant tout ou partie de la plage de mesure de la voie. Si par exemple N = 5 pour couvrir de préférence toute l'échelle du convertisseur ADC 10, alors les signaux de test analogiques appliqués à l'entrée 11 du convertisseur ADC 10 peuvent dans ce cas avoir comme valeur : 0V, 1V, 2V, 3V et 4V. Ces signaux numériques de test sont déclenchés périodiquement par l'unité de commande 50 pour tester régulièrement les mesures faites sur cette voie, par exemple toutes les dix secondes. L'unité de commande 50 peut évidemment tester de la même façon les autres voies du module.

Pour que ce procédé de vérification du fonctionnement du module conduise au résultat escompté, on a vu qu'il convient que les tensions d'alimentation des convertisseurs ADC 10 et DAC 20 soient distinctes. Par «distinctes», on entend qu'une variation de l'une des deux tensions d'alimentation ne doit pas générer une variation proportionnelle de l'autre et qu'une variation de la source externe commune 31 doit pas générer des variations des deux tensions d'alimentation proportionnelles entre elles, de façon à ce que la relation de correspondance ne soit plus vérifiée lorsqu'une des tensions d'alimentation varie.

Une façon simple d'avoir des tensions d'alimentation des convertisseurs ADC 10 et DAC 20 distinctes est d'avoir des tensions nominales $V_1$ et $V_2$ de valeurs différentes, par exemple 4V et 5V.

Ces conditions se traduisent par le fait que le rapport St / Sr n'est égal au rapport de correspondance prédéterminé des tensions d'alimentation des deux convertisseurs que si le fonctionnement du module est correct.

La figure 1 montre que les tensions nominales d'alimentation $V_1$ et $V_2$ peuvent être obtenues à partir d'une source 31 de tension commune et externe au module, à savoir par exemple une tension de 12V circulant sur le bus fond de panier de l'automate et à partir d'un transformateur 30, de façon à isoler les tensions de la source de tension externe et du module.

Selon une première variante, le deuxième régulateur 25 est directement alimenté par le secondaire du transformateur 30 et fournit en sortie une tension régulée à 5V qui alimente à la fois le convertisseur DAC 20 ainsi que l'entrée du premier régulateur 15 de 4V.

Selon une deuxième variante, le deuxième régulateur 25 est directement alimenté par un enroulement secondaire du transformateur 30 et le premier régulateur 15' (indiqué en traits pointillés sur la figure 1) est également directement alimenté par un autre enroulement secondaire du transformateur 30. Une autre configuration équivalente possible, non représentée, consisterait à alimenter les régulateurs 15' et 25 en parallèle sur le même secondaire du transformateur 30, ces deux régulateurs ayant des tensions de sortie différentes, par exemple de 4V et 5V respectivement.

On va maintenant montrer sur quelques exemples de dysfonctionnement simples comment la mise en oeuvre du procédé selon l'invention permet de vérifier le test d'intégrité du module. Nous supposons que la tension nominale de la source externe 31 est de 12V (= primaire du transformateur 30), que le secondaire du transformateur 30 fournit par exemple une tension égale à 6V et que les régulateurs 15 et 25 sont montés en cascade comme dans la figure 1, c'est-à-dire que le second régulateur 25 est alimenté par le secondaire du transformateur 30 et que le premier régulateur 15 est alimenté par la tension de sortie du second régulateur 25.

- Si la tension de la source externe 31 diminue légèrement en passant de 12V à 11V par exemple, alors le secondaire du transformateur 30 fournit une tension environ égale à 6V*(11/12), soit 5,5V. Le deuxième régulateur 25 est alors toujours en mesure de fournir une tension nominale de 5V et le premier régulateur 15 une tension nominale de 4V. Donc les convertisseurs ADC 10 et DAC 20 sont correctement alimentés avec leur tension nominale et le fonctionnement du module est correct. L'unité de commande 50 détecte bien un rapport St / Sr égal au rapport de correspondance 4/5.

- Si la tension de la source externe 31 diminue à 9 V, alors le secondaire du transformateur 30 fournit une tension environ égale à 6V*(9/12), soit 4,5V seulement. Dans ce cas, la sortie du deuxième régulateur 25 est limitée à 4,5V et la tension d'alimentation du convertisseur ADC 10 est limitée à 4,5V ce qui entraine des erreurs dans la conversion des mesures analogiques. Néanmoins, cette tension de 4,5 V est suffisante pour que le premier régulateur 15 continue à fournir une tension nominale de 4V au convertisseur DAC 20. Dans ce cas, le rapport St / Sr est égal à seulement 4/4,5, c'est-à-dire différent du rapport de correspondance 4/5. L'unité de commande 50 est donc capable de détecter ce mauvais fonctionnement.

- Si la tension de la source externe 31 diminue à 7 V, alors le secondaire du transformateur 30 fournit une tension environ égale à 6V*(7/12), soit 3,5V seulement. Dans ce cas, la sortie du deuxième régulateur 25 est limitée à 3,5V et la tension d'alimentation du convertisseur ADC 10 est limitée à 3,5V ce qui entraine des erreurs dans la conversion des mesures analogiques. Cette tension de 3,5 V n'est pas non plus suffisante pour que le premier régulateur 15 continue à fournir une tension nominale de 4V au convertisseur DAC 20. Le premier régulateur 15 ne fournit que 3,5V au convertisseur DAC 20. Dans ce cas, le rapport St / Sr sera égal à 3,5/3,5, soit 1, c'est-à-dire différent du rapport de correspondance 4/5. L'unité de commande 50 est là aussi capable de détecter ce mauvais fonctionnement.

D'autre part, on peut vérifier que :

- Si un défaut du régulateur 15 génère une tension d'alimentation du convertisseur ADC 10 différente de sa valeur nominale $V_1$ de 4V alors que la tension d'alimentation du convertisseur DAC 20 est égale à sa valeur nominale $V_2$ de 5V, le rapport St / Sr sera également faux. Un défaut de la voie du module est alors détecté par l'unité de commande 50.

- De même, si un défaut du régulateur 25 génère une tension d'alimentation du convertisseur DAC 20 différente de sa valeur nominale $V_2$ de 5V alors que la tension d'alimentation du convertisseur ADC 10 est égale à sa valeur nominale $V_1$ de 4V, le rapport St / Sr sera également faux. Un défaut de la voie du module est alors détecté par l'unité de commande 50.

- De plus, si le fonctionnement interne d'un des convertisseurs 10 ou 20 n'est pas correct ou si la communication devient impossible avec au moins un des convertisseurs 10, 20, alors le rapport St / Sr sera également faux.

Ainsi, on voit que tous ces cas de dysfonctionnement modifient le rapport St / Sr par rapport au rapport de correspondance théorique de $V_1/V_2$, cette modification étant détectée par l'unité de commande 50. L'architecture du module de sécurité proposée par l'invention permet donc d'effectuer ce premier test d'intégrité.

Le procédé prévoit également un second test complémentaire permettant de vérifier le fonctionnement de la chaîne de mesure de chaque voie du module d'entrées analogiques, c'est-à-dire en particulier la conformité de l'impédance $R_a$ d'adaptation à sa valeur nominale. Pour cela, le module comporte un convertisseur DAC 20 dual à deux sorties, c'est-à-dire comportant deux sorties indépendantes 22 et 23. Le pilotage de l'une ou l'autre de ces sorties 22, 23 peut être effectué par l'unité de commande 50, par exemple via le signal numérique d'entrée reçu sur l'entrée 21 ou via un signal de commande distinct. Pour le second test, c'est la seconde sortie 23 qui est utilisée alors que pour le premier test, c'est la première sortie 22 qui est utilisée.

La sortie 23 est connectée à l'entrée 11 du convertisseur ADC 10 au travers d'une impédance de charge Rs, comme indiqué en figure 1, qui est de préférence une simple résistance. Donc, à cause de cette résistance Rs, lorsqu'un signal analogique est activé sur la seconde sortie 23, ce signal analogique ne fait que modifier la valeur lue par le convertisseur ADC 10 d'un signal de mesure présent sur la borne d'entrée 41 de la voie, contrairement au premier test d'intégrité dans lequel la sortie 22 du convertisseur DAC 20 était directement connectée sous basse impédance à l'entrée 11 du convertisseur ADC 10, de façon à forcer la valeur lue par le convertisseur ADC 10.

Bien entendu, au lieu d'un convertisseur DAC dual à deux sorties, on pourrait utiliser un deuxième convertisseur DAC distinct du convertisseur DAC 20, mais cette solution est plus chère et plus encombrante. En effet, un convertisseur DAC à deux sorties présente l'avantage d'être un produit courant, pas plus encombrant qu'un convertisseur DAC à une seule sortie.

En fonctionnement normal, le capteur analogique 40 fournit un signal analogique E de mesure. En fait, de façon classique, le capteur 40 fournit un courant dans la gamme 4-20mA qui est ensuite transformé en tension. Si le module fonctionne correctement, le signal numérique S lu par l'unité de commande 50 sur son entrée 51 reproduit le signal de mesure E converti sous forme numérique. Pour simplifier, on écrira S = E.

Pour réaliser ce deuxième test, l'unité de commande 50 applique un signal numérique de test St' sur l'entrée 21 du convertisseur DAC 20 et commande la deuxième sortie 23 du convertisseur DAC 20. En réponse à ce signal de test St', le convertisseur DAC 20 fournit sur sa deuxième sortie 23 un signal analogique de test E'. Le signal numérique résultant S' lu par l'unité de commande 50 provient alors de la conversion numérique de la combinaison des signaux E et E', à savoir :

$$S' = (R_s/(R_s + R_a))*E + (R_a/(R_s + R_a))*E' = (R_s/(R_s + R_a))*S + (R_a/(R_s + R_a))*St'$$

Dans ces équations, les paramètres $R_a$ et $R_s$ sont connus. Le signal analogique de test E' est également connu car l'unité de commande 50 applique un signal numérique de test St' connu. Par ailleurs, on suppose que E est mesuré et reste constant pendant le test, c'est-à-dire avant et après l'application du signal E'. La différence S' - S est alors donnée par :

$$S' - S = (S - St')*(R_a/(R_s + R_a))$$

Les moyens de traitement et de mémorisation de l'unité de commande 50 sont évidemment capables de lire et mémoriser les signaux S et S', de mémoriser des valeurs nominales de $R_a$ et $R_s$, et de comparer les valeurs des signaux S et S' pour vérifier que ces valeurs sont conformes aux équations ci-dessus.

Le second test peut donc être réalisé de manière extrêmement simple : le procédé consiste donc uniquement à lire et enregistrer un premier signal numérique de mesure S représentatif du signal analogique de mesure E en provenance du capteur 40 alors que la sortie 23 du convertisseur DAC 20 n'est pas activée, puis à appliquer un signal numérique de test St' de valeur connue sur l'entrée 21 du convertisseur DAC 20 de façon à générer un signal analogique de test E', puis à lire et enregistrer un second signal numérique S' résultant de la combinaison des signaux analogiques E et E', et enfin à comparer les signaux enregistrés S et S' pour s'assurer que les équations ci-dessus sont bien respectées, de façon à vérifier le fonctionnement du module.

Si la valeur S - S' n'est pas celle attendue, alors cela signifie que la valeur de l'impédance $R_a$ d'adaptation ou celle de la résistance $R_s$ de charge, n'est pas conforme. L'unité de commande 50 est alors capable de signaler ce défaut à l'unité centrale de l'automate programmable.

Ainsi, il est possible de tester complètement le bon fonctionnement du module d'entrées analogiques, sachant par ailleurs que comme les entrées analogiques sont calibrées entre 4 et 20mA, le défaut de "fil coupé" entre le capteur 40 et l'entrée du convertisseur ADC 10 est détecté lorsqu'une tension correspondant à un courant de 0mA est mesuré sur le convertisseur ADC 10.

**Revendications**

**1.** Procédé de vérification du fonctionnement d'un module d'entrées analogiques d'un automate programmable, ledit module comprenant un convertisseur analogique/numérique ADC (10) qui est apte à convertir un signal analogique reçu sur une entrée (11) en un signal numérique délivré sur une sortie (12), et qui est alimenté par une première tension de valeur nominale $V_1$, **caractérisé en ce que** le procédé comprend les étapes consistant à :

- équiper le module d'un convertisseur numérique/analogique DAC (20) comportant une première sortie (22) connectée à l'entrée (11) du convertisseur ADC (10) et une entrée (21), le convertisseur DAC (20) étant apte à convertir un signal numérique reçu sur l'entrée (21) en un signal analogique délivré sur la première sortie (22), et alimenté par une deuxième tension de valeur nominale $V_2$ distincte de la première tension nominale $V_1$,
- appliquer un signal numérique de test St sur l'entrée (21) du convertisseur DAC (20) et lire un signal numérique de réponse Sr correspondant délivré sur la sortie (12) du convertisseur ADC (10),
- comparer ledit signal de test St audit signal de réponse Sr, à l'aide d'un rapport de correspondance prédéterminé entre les tensions nominales $V_1$ et $V_2$, pour vérifier le fonctionnement du module.

2. Procédé de vérification selon la revendication 1, **caractérisé en ce que** le procédé applique périodiquement plusieurs signaux numériques de test St couvrant une plage de mesure du convertisseur ADC (10), et compare chaque signal de test St à un signal de réponse correspondant Sr, à l'aide du rapport de correspondance prédéterminé.

3. Procédé de vérification selon la revendication 1, dans lequel l'entrée (11) du convertisseur ADC (10) est reliée à une borne d'entrée (41) d'une voie de mesure du module au travers d'une impédance d'adaptation Ra, **caractérisé en ce que** ledit procédé comprend également les étapes consistant à :

- connecter une seconde sortie (23) du convertisseur DAC (20) à l'entrée (11) du convertisseur ADC (10) au moyen d'une impédance de charge Rs,
- lire un premier signal numérique de mesure S délivré sur la sortie (12) du convertisseur ADC (10) après conversion par le convertisseur ADC (10) d'un signal analogique E de mesure appliqué à ladite borne d'entrée (41),
- générer un signal analogique de test E' délivré par le convertisseur DAC (20) en réponse à un signal numérique de test St' appliqué à l'entrée (21) du convertisseur DAC (20),
- lire un second signal numérique S' délivré sur la sortie (12) après conversion par le convertisseur ADC (10) d'un signal analogique délivré sur l'entrée (11) du convertisseur ADC (10) résultant de la combinaison dudit signal analogique E de mesure et dudit signal analogique de test E',
- comparer le premier signal numérique S au second signal numérique S', à l'aide des valeurs nominales des impédances d'adaptation Ra et de charge $R_s$ et de la valeur du signal numérique de test St', pour vérifier le fonctionnement du module.

4. Module d'entrées analogiques d'un automate programmable, comprenant un convertisseur analogique/numérique ADC (10) qui est apte à convertir un signal analogique reçu sur une entrée (11) en un signal numérique délivré sur une sortie (12), et qui est alimenté par un premier régulateur de tension (15) sous une première tension de valeur nominale $V_1$, **caractérisé en ce que** le module comprend :

- un convertisseur numérique/analogique DAC (20) qui comporte une première sortie (22) connectée à l'entrée (11) du convertisseur ADC (10) et une entrée (21), le convertisseur DAC (20) étant apte à convertir un signal numérique reçu sur l'entrée (21) en un signal analogique délivré sur la première sortie (22), et qui est alimenté par un deuxième régulateur de tension (25) sous une deuxième tension de valeur nominale $V_2$ distincte de la première tension nominale $V_1$,
- une unité de commande (50) qui est apte à appliquer un signal numérique de test St sur l'entrée (21) du convertisseur DAC (20), à lire un signal numérique de réponse Sr correspondant délivré sur la sortie (12) du convertisseur ADC (10), et à comparer ledit signal de test St audit signal de réponse Sr, à l'aide d'un rapport de correspondance prédéterminé entre les tensions nominales $V_1$ et $V_2$, pour vérifier le fonctionnement du module.

5. Module d'entrées analogiques selon la revendication 4, **caractérisé en ce que** le premier régulateur de tension (15) est alimenté par la tension de sortie du deuxième régulateur de tension (25).

6. Module d'entrées analogiques selon la revendication 4, **caractérisé en ce que** les premier (15) et deuxième (25) régulateurs de tension sont alimentés en parallèle sous une même tension d'entrée.

7. Module d'entrées analogiques selon la revendication 4, **caractérisé en ce que** le convertisseur DAC (20) est un convertisseur DAC de type dual comprenant la première sortie (22) ainsi qu'une seconde sortie (23) reliée à l'entrée (11) du convertisseur ADC (10) au travers d'une impédance de charge Rs.

8. Module d'entrées analogiques selon la revendication 7, dans lequel le module comporte une borne d'entrée (41) d'une voie de mesure qui est connectée à l'entrée (11) du convertisseur ADC (10) au travers d'une impédance d'adaptation Ra, **caractérisé en ce que** l'une unité de commande (50) est apte à :

- lire un premier signal numérique de mesure S délivré sur la sortie (12) du convertisseur ADC (10) après conversion d'un signal analogique de mesure E appliqué à la borne d'entrée (41) du module,
- appliquer un signal numérique de test St' sur l'entrée (21) du convertisseur DAC (20) pour générer un signal analogique de test E' sur la seconde sortie (23) du convertisseur DAC (20),
- lire un second signal numérique de réponse S' correspondant délivré sur la sortie (12) du convertisseur ADC (10), résultant de la combinaison entre le signal analogique de mesure E et le signal analogique de test E',
- comparer le premier signal numérique S au second signal numérique S', à l'aide des valeurs nominales des impédances d'adaptation Ra et de charge $R_s$ et de la valeur du signal numérique de test St', pour vérifier le fonctionnement du module.

**Claims**

1. Method of checking the operation of an analog input module of a programmable logical controller, said module comprising an analog/digital converter ADC (10) which is able to convert an analog signal received on an input (11) into a digital signal delivered on an output (12), and which is supplied with a first voltage of nominal value $V_1$, **characterized in that** the method comprises the steps consisting in:

   - equipping the module with a digital/analog converter DAC (20) comprising a first output (22) connected to the input (11) of the ADC converter (10) and an input (21), the DAC converter (20) being able to convert a digital signal received on the input (21) into an analog signal delivered on the first output (22), and supplied with a second voltage of nominal value $V_2$ different from the first nominal voltage $V_1$,
   - applying a digital test signal St to the input (21) of the DAC converter (20) and reading a corresponding digital response signal Sr delivered on the output (12) of the ADC converter (10),
   - comparing said test signal St with said response signal Sr, with the aid of a predetermined correspondence ratio between the nominal voltages $V_1$ and $V_2$, so as to check the operation of the module.

2. Method according to Claim 1, **characterized in that** the method periodically applies several digital test signals St covering a measurement span of the ADC converter (10), and compares each test signal St with a corresponding response signal Sr, with the aid of the predetermined correspondence ratio.

3. Method according to Claim 1, in which the input (11) of the ADC converter (10) is linked to an input terminal (41) of a measurement channel of the module across an adaptation impedance $R_a$, **characterized in that** the method also comprises the steps consisting in:

   - connecting a second output (23) of the DAC converter (20) to the input (11) of the ADC converter (10) by means of a load impedance $R_s$,
   - reading a first digital measurement signal S delivered on the output (12) of the ADC converter (10) after conversion by the ADC converter (10) of an analog measurement signal E applied to said input terminal (41),
   - generating an analog test signal E' delivered by the DAC converter (20) in response to a digital test signal St' applied to the input (21) of the DAC converter (20),
   - reading a second digital signal S' delivered on the output (12) after conversion by the ADC converter (10) of an analog signal delivered on the input (11) of the ADC converter (10) resulting from the combination of said analog measurement signal E and of said analog test signal E',
   - comparing the first digital signal S with the second digital signal S', with the aid of the nominal values of the adaptation impedance $R_a$ and load impedance $R_s$ and of the value of the digital test signal St', so as to check the operation of the module.

4. Analog input module of a programmable logical controller, comprising an analog/digital converter ADC (10) which is able to convert an analog signal received on an input (11) into a digital signal delivered on an output (12), and which is supplied through a first voltage regulator (15) at a first voltage of nominal value $V_1$, **characterized in that** the module comprises:

   - a digital/analog converter DAC (20) which comprises a first output (22) connected to the input (11) of the ADC converter (10) and an input (21), the DAC converter (20) being able to convert a digital signal received on the input (21) into an analog signal delivered on the first output (22), and which is supplied through a second voltage regulator (25) at a second voltage of nominal value $V_2$ different from the first nominal voltage $V_1$,
- a control unit (50) which is able to apply a digital test signal St to the input (21) of the DAC converter (20), to read a corresponding digital response signal Sr delivered on the output (12) of the ADC converter (10), and to compare said test signal St with said response signal Sr, with the aid of a predetermined correspondence ratio between the nominal voltages $V_1$ and $V_2$, so as to check the operation of the module.

5. Analog input module according to Claim 4,
   **characterized in that** the first voltage regulator (15) is supplied with the output voltage of the second voltage regulator (25).

6. Analog input module according to Claim 4,
   **characterized in that** the first (15) and second (25) voltage regulators are supplied in parallel at one and the same input voltage.

7. Analog input module according to Claim 4,
   **characterized in that** the DAC converter (20) is a DAC converter of dual type comprising the first output (22) as well as a second output (23) linked to the input (11) of the ADC converter (10) across a load impedance $R_s$.

8. Analog input module according to Claim 7, comprising an input terminal (41) of a measurement channel which is connected to the input (11) of the ADC converter (10) across an adaptation impedance $R_a$, **characterized in that** the control unit (50) is configured to:

   - read a first digital measurement signal S delivered on the output (12) of the ADC converter (10) after conversion of an analog measurement signal E applied to the input terminal (41) of the module,
   - apply a digital test signal St' to the input (21) of the DAC converter (20) so as to generate an analog test signal E' on the second output (23) of the DAC converter (20),
   - read a corresponding second digital response signal S' delivered on the output (12) of the ADC converter (10), resulting from the combination between the analog measurement signal E and the analog test signal E',
   - compare the first digital signal S with the second digital signal S', with the aid of the nominal values of the adaptation impedance $R_a$ and load impedance $R_s$ and of the value of the digital test signal St', so as to check the operation of the module.

**Patentansprüche**

1. Verfahren zur Überprüfung des Betriebs eines analoger Eingangsmoduls einer programmierbaren Steuerung, wobei das Modul einen Analog/Digital-Wandler ADC (10) enthält, der ein an einem Eingang (11) empfangenes Signal in ein digitales Signal umwandeln kann, das an einem Ausgang (12) geliefert wird, und der mit einer ersten Nennwert-spannung $V_1$ gespeist wird, wobei das Verfahren die Schritte enthält, die darin bestehen:

   - das Modul mit einem Digital/Analog-Wandler DAC (20) auszustatten, der einen ersten Ausgang (22), der mit dem Eingang (11) des Wandlers ADC (10) verbunden ist, und einen Eingang (21) aufweist, wobei der Wandler DAC (20) ein am Eingang (21) empfangenes digitales Signal umwandeln kann, das am ersten Ausgang (22) geliefert wird, und der mit einer zweiten Nennwertspannung $V_2$ gespeist wird, die sich von der ersten Nenn-spannung $V_1$ unterscheidet,
   - ein digitales Testsignal St an den Eingang (21) des Wandlers DAC (20) anzulegen und ein entsprechendes Antwortsignal Sr abzulesen, das am Ausgang (12) des Wandlers ADC (10) geliefert wird,
   - das Testsignal St mit Hilfe eines vorbestimmten Entsprechungsverhältnisses zwischen den Nennspannungen $V_1$ und $V_2$ mit dem Antwortsignal Sr zu vergleichen, um den Betrieb des Moduls zu überprüfen.

2. Verfahren nach Anspruch 1, **dadurch gekennzeichnet, dass** das Verfahren periodisch mehrere digitale Testsignale St anlegt, die einen Messbereich des Wandlers ADC (10) abdecken, und mit Hilfe des vorbestimmten Entsprechungsverhältnisses jedes Testsignal St mit einem entsprechenden Antwortsignal Sr vergleicht.

3. Verfahren nach Anspruch 1, bei dem der Eingang (11) des Wandlers ADC (10) mit einer Eingangsklemme (41) eines Messkanals des Moduls über eine Anpassungsimpedanz Ra verbunden ist, **dadurch gekennzeichnet, dass** das Verfahren ebenfalls die Schritte enthält, die darin bestehen:

- einen zweiten Ausgang (23) des Wandlers DAC (20) über eine Lastimpedanz Rs mit dem Eingang (11) des Wandlers ADC (10) zu verbinden,

- ein erstes digitales Messsignal S abzulesen, das am Ausgang (12) des Wandlers ADC (10) nach Umwandlung durch den Wandler ADC (10) eines analogen Messsignals E geliefert wird, das an die Eingangsklemme (41) angelegt wird,

- ein analoges Testsignal E' zu erzeugen, das vom Wandler DAC (20) als Antwort auf ein digitales Testsignal St' geliefert wird, das an den Eingang (21) des Wandlers DAC (20) angelegt wird,

- ein zweites digitales Signal S' abzulesen, das am Ausgang (12) nach Umwandlung durch den Wandler ADC (10) eines an den Eingang (11) des Wandlers ADC (10) gelieferten analogen Signals geliefert wird, das aus der Kombination des analogen Messsignals E und des analogen Testsignals E' resultiert,

- das erste digitale Signal S mit Hilfe der Nennwerte der Anpassungsimpedanz Ra und der Lastimpedanz $R_s$ und des Werts des digitalen Testsignals St' mit dem zweiten digitalen Signal S' zu vergleichen, um den Betrieb des Moduls zu überprüfen.

4.  Analog EingangsModul einer programmierbaren Steuerung, das einen Analog/Digital-Wandler ADC (10) enthält, der ein an einem Eingang (11) empfangenes analoges Signal in ein digitales Signal umwandeln kann, das an einem Ausgang (12) geliefert wird, und der von einem ersten Spannungsregler (15) mit einer ersten Nennwertspannung $V_1$ gespeist wird, **dadurch gekennzeichnet, dass** das Modul enthält:

    - einen Digital/Analog-Wandler DAC (20), der einen ersten Ausgang (22), der mit dem Eingang (11) des Wandlers ADC (10) verbunden ist, und einen Eingang (21) aufweist, wobei der Wandler DAC (20) ein am Eingang (21) empfangenes digitales Signal in ein analoges Signal umwandeln kann, das am ersten Ausgang (22) geliefert wird, und der von einem zweiten Spannungsregler (25) mit einer zweiten Nennwertspannung $V_2$ gespeist wird, die sich von der ersten Nennspannung $V_1$ unterscheidet,

    - eine Steuereinheit (50), die ein digitales Testsignal St an den Eingang (21) des Wandlers DAC (20) anlegen, ein entsprechendes, am Ausgang (12) des Wandler ADC (10) geliefertes digitales Antwortsignal Sr ablesen, und das Testsignal St mit Hilfe eines vorbestimmten Entsprechungsverhältnisses zwischen den Nennspannungen $V_1$ und $V_2$ mit dem Antwortsignal Sr vergleichen kann, um den Betrieb des Moduls zu überprüfen.

5.  Analog EingangsModul nach Anspruch 4, **dadurch gekennzeichnet, dass** der erste Spannungsregler (15) mit der Ausgangsspannung des zweiten Spannungsreglers (25) gespeist wird.

6.  Analog EingangsModul nach Anspruch 4, **dadurch gekennzeichnet, dass** der erste (15) und der zweite Spannungsregler (25) mit der gleichen Eingangsspannung parallel gespeist werden.

7.  Analog EingangsModul nach Anspruch 4, **dadurch gekennzeichnet, dass** der Wandler DAC (20) ein Wandler DAC vom dualen Typ ist, der den ersten Ausgang (22) sowie einen zweiten Ausgang (23) enthält, der mit dem Eingang (11) des Wandlers ADC (10) über eine Lastimpedanz Rs verbunden ist.

8.  Analog EingangsModul nach Anspruch 7, bei dem das Modul eine Eingangsklemme (41) eines Messkanals aufweist, die mit dem Eingang (11) des Wandlers ADC (10) über eine Anpassungsimpedanz Ra verbunden ist, **dadurch gekennzeichnet, dass** die Steuereinheit (50) in der Lage ist:

    - ein erstes digitales Messsignal S abzulesen, das am Ausgang (12) des Wandlers ADC (10) nach Umwandlung eines analogen Messsignals E geliefert wird, das an die Eingangsklemme (41) des Moduls angelegt wird,

    - ein digitales Testsignal St' an den Eingang (21) des Wandlers DAC (20) anzulegen, um ein analoges Testsignal E' am zweiten Ausgang (23) des Wandlers DAC (20) zu erzeugen,

    - ein zweites entsprechendes digitales Antwortsignal S' abzulesen, das am Ausgang (12) des Wandlers ADC (10) geliefert wird, resultierend aus der Kombination zwischen dem analogen Messsignal E und dem analogen Testsignal E',

    - das erste digitale Signal S mit Hilfe der Nennwerte der Anpassungsimpedanz Ra und der Lastimpedanz $R_s$ und des Werts des digitalen Testsignals St' mit dem zweiten digitalen Signal S' zu vergleichen, um den Betrieb des Moduls zu überprüfen.

**FIG. 1**

**EP 2 066 037 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 4580126 A